# EUROPEAN PATENT APPLICATION

(11) **EP 4 075 483 A1**
(43) Date of publication of application: **19.10.2022**
(21) Application number: 20899537.3
(22) Date of filing: 02.12.2020
(51) Int. Cl.: H01L 21/56, H01L 27/146, H04N 5/369

(54) **IMAGING ELEMENT PACKAGE AND METHOD OF MANUFACTURING IMAGING ELEMENT PACKAGE**

(30) Priority: 09.12.2019 JP 2019222524
(71) Applicant: Sony Semiconductor Solutions Corporation, Atsugi-shi Kanagawa 243-0014 (JP)
(72) Inventor: FUSENO, Kei, Kikuchi-gun, Kumamoto 869-1102 (JP); KIMURA, Takashi, Kikuchi-gun, Kumamoto 869-1102 (JP); TAKEKUMA, Shohei, Kikuchi-gun, Kumamoto 869-1102 (JP); MATSUBARA, Youji, Kikuchi-gun, Kumamoto 869-1102 (JP)
(74) Representative: Müller Hoffmann & Partner
(86) International application number: PCT/JP2020/044943
(87) International publication number: WO 2021/117585

(57) **Abstract**

An imaging element package (1) according to the present disclosure includes a circuit board (2), an imaging element substrate (5), and a light-transmissive substrate (7). The imaging element substrate (5) is stacked on the circuit board (2). The light-transmissive substrate (7) is stacked on the imaging element substrate (5) via a void by an adhesive member provided on the peripheral edge of the light receiving surface of the imaging element substrate (5), and has higher heat resistance than the imaging element substrate (5). The imaging element package (1) further includes a frame-shaped frame body (6) stacked on the circuit board (2). The imaging element substrate (5) and the light-transmissive substrate (7) are housed in a region surrounded by the frame body (6).

## Description

### FIELD

The present disclosure relates to an imaging element package and a method of manufacturing the imaging element package.

### BACKGROUND

There is provided an imaging element package including a frame-shaped frame body stacked on a circuit board, an imaging element substrate stacked on a region of the circuit board surrounded by the frame body, and a cover glass that is stacked on the frame body and closes an opening of the frame body (e.g., see Patent Literature 1).

### CITATION LIST

### PATENT LITERATURE

Patent Literature 1: JP 2013-222772 A

### SUMMARY

### TECHNICAL PROBLEM

Unfortunately, in an imaging element package, when the area of an imaging element substrate increases with the expansion of a light receiving region, the imaging element substrate is warped by heat treatment included in a manufacturing process, which reduces quality.

Therefore, the present disclosure proposes an imaging element package and a method of manufacturing the imaging element package capable of inhibiting the warpage of an imaging element substrate.

### SOLUTION TO PROBLEM

According to the present disclosure, an imaging element package is provided. The imaging element package includes a circuit board, an imaging element substrate, and a light-transmissive substrate. The imaging element substrate is stacked on the circuit board. The light-transmissive substrate is stacked on the imaging element substrate via a void by an adhesive member provided on the peripheral edge of the light receiving surface of the imaging element substrate, and has higher heat resistance than the imaging element substrate.

### BRIEF DESCRIPTION OF DRAWINGS

FIG. 1 is an explanatory view outlining the cross-sectional structure of an imaging element package according to the present disclosure.
FIG. 2A is a cross-sectional explanatory view illustrating a manufacturing process of the imaging element package according to the present disclosure.
FIG. 2B is a cross-sectional explanatory view illustrating the manufacturing process of the imaging element package according to the present disclosure.
FIG. 2C is a cross-sectional explanatory view illustrating the manufacturing process of the imaging element package according to the present disclosure.
FIG. 3A is a cross-sectional explanatory view illustrating the manufacturing process of the imaging element package according to the present disclosure.
FIG. 3B is a cross-sectional explanatory view illustrating the manufacturing process of the imaging element package according to the present disclosure.
FIG. 3C is a cross-sectional explanatory view illustrating the manufacturing process of the imaging element package according to the present disclosure.
FIG. 4A is a cross-sectional explanatory view illustrating the manufacturing process of the imaging element package according to the present disclosure.
FIG. 4B is a cross-sectional explanatory view illustrating the manufacturing process of the imaging element package according to the present disclosure.
FIG. 4C is a cross-sectional explanatory view illustrating the manufacturing process of the imaging element package according to the present disclosure.
FIG. 5 is an explanatory view of the timing of curing a filling member according to the present disclosure.
FIG. 6A is a cross-sectional explanatory view illustrating a configuration example of a light-transmissive substrate according to the present disclosure.
FIG. 6B is a cross-sectional explanatory view illustrating the configuration example of the light-transmissive substrate according to the present disclosure.
FIG. 7A is a cross-sectional explanatory view illustrating the configuration example of the light-transmissive substrate according to the present disclosure.
FIG. 7B is a cross-sectional explanatory view illustrating the configuration example of the light-transmissive substrate according to the present disclosure.
FIG. 8 is a cross-sectional explanatory view illustrating the configuration example of the light-transmissive substrate according to the present disclosure.

### DESCRIPTION OF EMBODIMENTS

An embodiment of the present disclosure will be described in detail below with reference to the drawings. Note that, in the following embodiment, the same signs are attached to the same parts to omit duplicate description.

### [1. Cross-sectional Structure of Imaging Element Package]

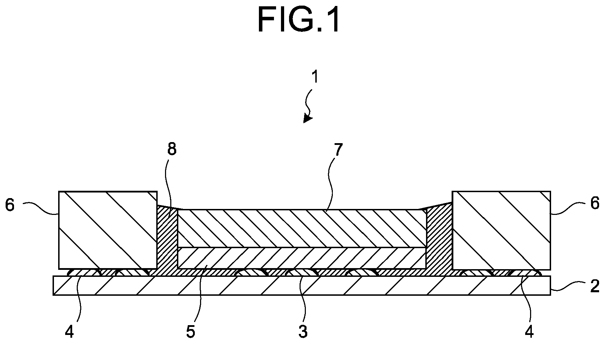

First, the cross-sectional structure of an imaging element package according to the present disclosure will be described with reference to FIG. 1. FIG. 1 is an explanatory view outlining the cross-sectional structure of the imaging element package according to the present disclosure.

The imaging element package according to the present disclosure is, for example, an imaging device mounted in a smartphone or a tablet terminal. As illustrated in FIG. 1, an imaging element package 1 includes a circuit board 2, a bump 3, a dam material 4, an imaging element substrate 5, a frame body 6, a light-transmissive substrate 7, and a filling member 8.

The circuit board 2 is formed of, for example, ceramic. A circuit pattern to be connected to the imaging element substrate 5 is formed on the circuit board 2. Note that the circuit board 2 is not limited to a ceramic substrate, and may be, for example, another substrate such as an organic substrate and a flexible substrate.

The bump 3 is formed of, for example, solder. The bump 3 electrically connects a circuit pattern formed on the circuit board 2 and a circuit pattern formed on the imaging element substrate 5. The dam material 4 is formed of, for example, epoxy resin. The dam material 4 fixes the frame body 6 on the circuit board 2, and prevents the filling member 8 from leaking to the outside of the imaging element package 1.

The imaging element substrate 5 is stacked on the circuit board 2 via the bump 3. The imaging element substrate 5 is formed of, for example, silicon, and has a rectangular shape in plan view. The imaging element substrate 5 includes a pixel array in which a plurality of photoelectric conversion elements serving as imaging pixels is arranged in a matrix on a light receiving surface (here, upper surface) on a light incident side.

Each photoelectric conversion element photoelectrically converts incident light into a signal charge in accordance with an amount of received incident light, and outputs the signal charge as a pixel signal indicating a level of the luminance of an imaging pixel. Furthermore, the imaging element substrate 5 includes a peripheral circuit, which performs signal processing on a pixel signal, around the pixel array.

The frame body 6 is formed of, for example, ceramic. The frame body 6 is stacked on the circuit board 2 via the bump 3 and the dam material 4. The frame body 6 has a frame shape in plan view. Note that the frame body 6 may be a ceramic frame without substrate wiring. Furthermore, the material of the frame body 6 is not limited to ceramic. For example, an organic substrate and a metal plate may be used as the material of the frame body 6.

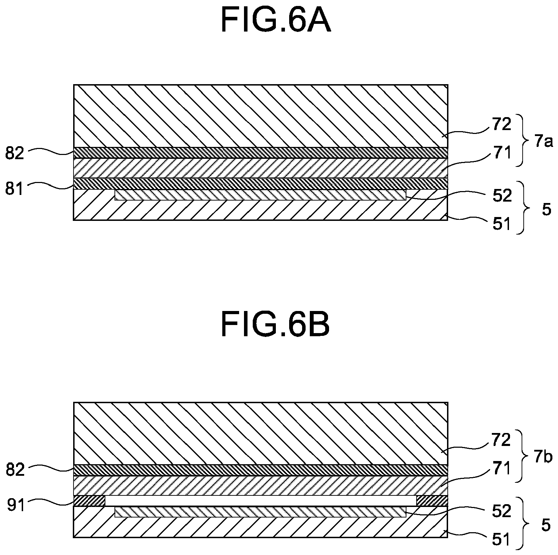

The light-transmissive substrate 7 is formed of a material having higher heat resistance than the imaging element substrate 5, and is stacked on the imaging element substrate 5. The light-transmissive substrate 7 includes, for example, an infrared cut filter substrate formed of glass. Note that a specific configuration example of the light-transmissive substrate 7 will be described later with reference to FIGS. 6A to 8.

The imaging element substrate 5 and the light-transmissive substrate 7 are housed in a region surrounded by the frame body 6 on the circuit board 2. In this state, the height position of the upper surface serving as a light receiving surface of the light-transmissive substrate 7 is lower than the height position of the upper surface of the frame body 6.

The filling member 8 is formed of, for example, thermosetting resin such as epoxy resin. The space between the imaging element substrate 5 and the light-transmissive substrate 7 and the frame body 6 is filled with the filling member 8. The filling member 8 prevents occurrence of disconnection between the imaging element substrate 5 and the circuit board 2, for example, when the imaging element package 1 receives an impact.

Here, in a common imaging element package, the light-transmissive substrate 7 including the infrared cut filter substrate is stacked not on the imaging element substrate 5 but on the frame body 6. Thus, in a common imaging element package, when the area of the imaging element substrate 5 increases with the expansion of a light receiving region, the imaging element substrate 5 is warped by heat treatment included in a manufacturing process, which reduces quality. Furthermore, since in a common imaging element package, the light-transmissive substrate 7 is stacked on the frame body 6, the thickness of the entire package increases by the thickness of the light-transmissive substrate 7, which prevents reduction in height.

In contrast, in the imaging element package 1 according to the present disclosure, the light-transmissive substrate 7 is stacked not on the frame body 6 but on the imaging element substrate 5. Then, as described above, the light-transmissive substrate 7 is formed of a material having higher heat resistance than the imaging element substrate 5.

As a result, in the imaging element package 1, when heat treatment is performed in a manufacturing process, in which only the imaging element substrate 5 is provided, at a temperature at which the imaging element substrate 5 is warped, the occurrence of the warpage can be inhibited by correcting the warpage of the imaging element substrate 5 with the light-transmissive substrate 7, which is hardly deformed by heat.

Furthermore, in the imaging element package 1, the imaging element substrate 5 and the light-transmissive substrate 7 are housed in a region surrounded by the frame body 6 on the circuit board 2. As a result, in the imaging element package 1, the upper surface position of the light-transmissive substrate 7 can be lowered below the upper surface position of the frame body 6, so that the height can be more reduced than that of a common imaging element package in which the light-transmissive substrate 7 is stacked on the frame body 6.

### [2. Manufacturing Process of Imaging Element Package]

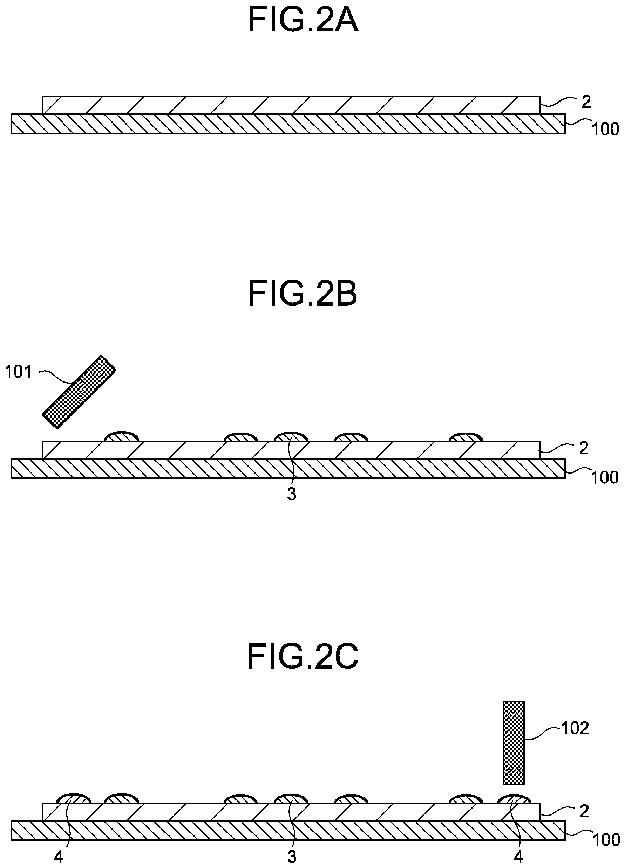

Next, a manufacturing process of the imaging element package according to the present disclosure will be described with reference to FIGS. 2A to 4C. FIGS. 2A to 4C are cross-sectional explanatory views illustrating the manufacturing process of the imaging element package according to the present disclosure.

As illustrated in FIG. 2A, when the imaging element package 1 is manufactured, first, the circuit board 2 is bonded to a support substrate 100. Here, in a manufacturing process of a common imaging element package, a sticky resin body is used as a support substrate.

The sticky resin body has a coefficient of thermal expansion (CTE) of approximately 360 [ppm/°C]. In contrast, the circuit board 2 made of ceramic has a CTE of approximately 5 [ppm/°C]. As described above, the sticky resin body has a CTE much larger than that of the circuit board 2. Thus, the sticky resin body used as a support substrate may increase an amount of warpage of the circuit board 2 in the subsequent heat treatment.

Therefore, in the present disclosure, the support substrate 100 formed of a material having a CTE with a difference of several tens ppm/°C or less from the CTE of the circuit board 2 is used. For example, the support substrate 100 formed of polyimide is used. Polyimide has a CTE of approximately 27 [ppm/°C] and the CTE is closer to the CTE of the circuit board 2 than to that of the sticky resin body. As a result, according to the present disclosure, the amount of warpage of the circuit board 2 due to the subsequent heat treatment can be reduced.

Then, as illustrated in FIG. 2B, for example, a solder printing device 101 forms the bump 3 at a predetermined position of the circuit board 2. Subsequently, as illustrated in FIG. 2C, a dam material coating device coats a peripheral edge portion of the circuit board 2 with the dam material 4.

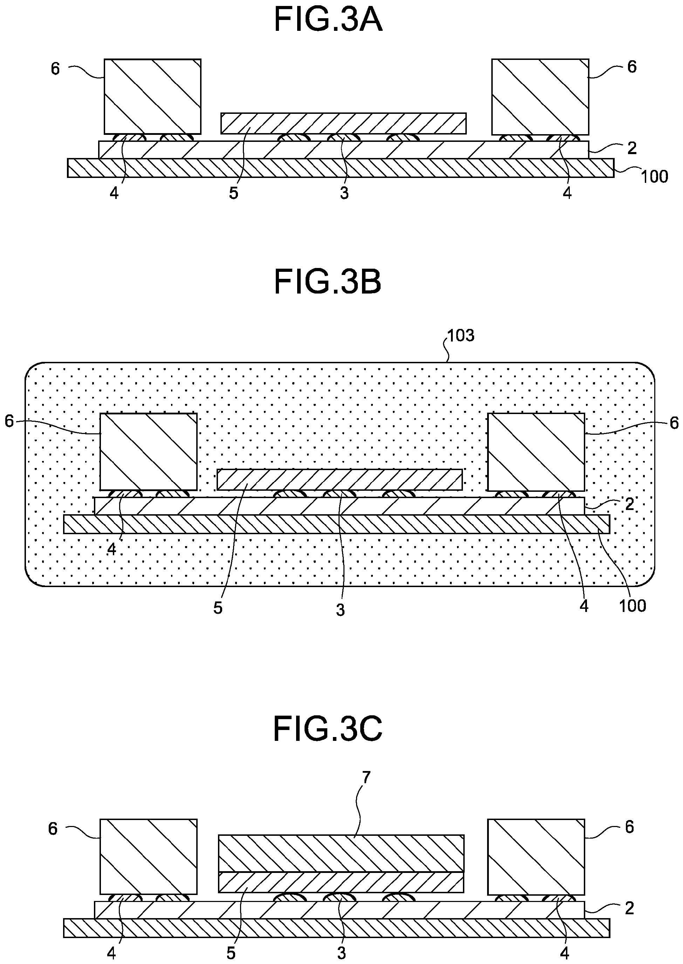

Then, as illustrated in FIG. 3A, the imaging element substrate 5 is stacked at a central position of the circuit board 2 via the bump 3. The frame body 6 is stacked on the circuit board 2 via the bump 3 and the dam material 4 so as to surround the imaging element substrate 5.

Subsequently, as illustrated in FIG. 3B, the structure in FIG. 3A is placed in a heat treatment device 103. Reflow is performed at 150 to 170[°C] for a predetermined period of time. The bump 3 is melted to electrically connect the circuit board 2 and the imaging element substrate 5 with each other.

At this time, the circuit board 2 is heat-treated, but warpage is inhibited since the circuit board 2 is bonded to the support substrate 100, which is formed of polyimide having a CTE close to the CTE of the circuit board 2 as described above. As a result, warpage due to heat treatment is similarly inhibited in the imaging element substrate 5 stacked on the circuit board 2.

Then, as illustrated in FIG. 3C, the light-transmissive substrate 7 is stacked on the imaging element substrate 5. A substrate formed of a material having a CTE with a difference within several ppm/°C from the CTE of the imaging element substrate 5 is used as the light-transmissive substrate 7. For example, when the imaging element substrate 5 is formed of silicon, a substrate formed of a material having a CTE of 3 to 5 [ppm/°C] close to the CTE of silicon (approximately 4 [ppm/°C]) is used.

Furthermore, when the imaging element substrate 5 has a thickness of 120 to 130 [µm], the light-transmissive substrate 7 has a thickness equivalent to or equal to or larger than that of the imaging element substrate 5. A substrate having a thickness of 200 to 300 [µm] is preferably used as the light-transmissive substrate 7.

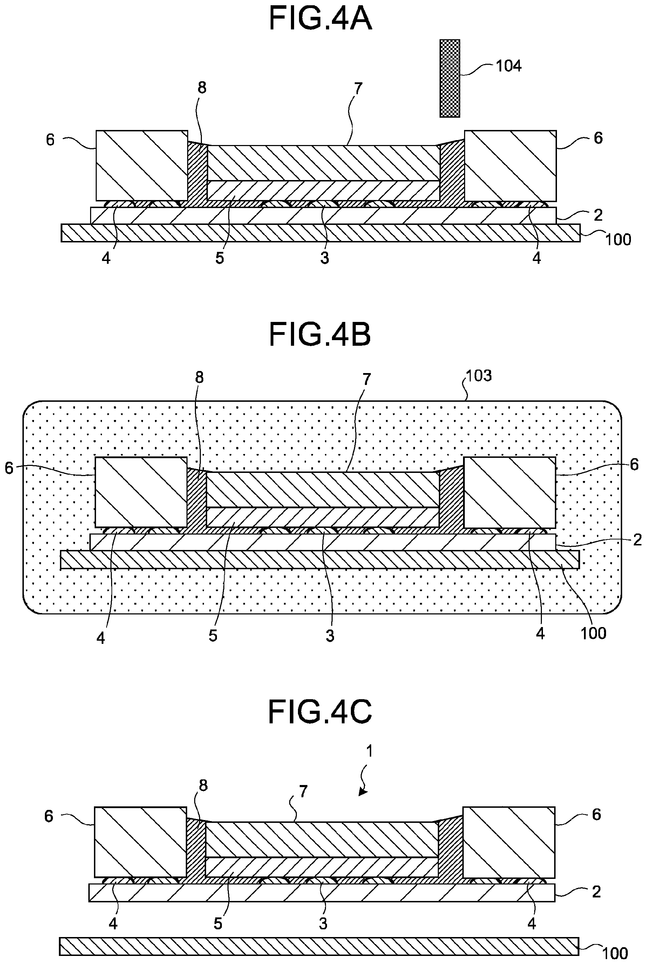

Subsequently, as illustrated in FIG. 4A, a resin coating device 104 fills the space between the imaging element substrate 5 and the light-transmissive substrate 7 and the frame body 6 with the filling member 8 of thermosetting resin in an environment of 100[°C], for example. Here, the space is filled with the filling member 8 having a higher elastic modulus than the circuit board 2.

The filling member 8 is made highly elastic by, for example, increasing the amount of filler (e.g., silicon oxide and aluminum oxide) mixed in common epoxy resin or acrylic resin. The filling member 8 preferably has an elastic modulus of, for example, 8 to 10 [GPa].

Then, as illustrated in FIG. 4B, the structure in FIG. 4A is placed in the heat treatment device 103, and cured at approximately 120[°C] for a predetermined period of time to thermally cure the filling member 8. At this time, the imaging element substrate 5 is heat-treated, but warpage due to the heat treatment is inhibited since the light-transmissive substrate 7 having higher heat resistance than the imaging element substrate 5 is stacked.

Furthermore, the warpage of the imaging element substrate 5 due to heat treatment is inhibited since the light-transmissive substrate 7 has a larger thickness than the imaging element substrate 5 and the light-transmissive substrate 7 has a CTE close to the CTE of the imaging element substrate 5.

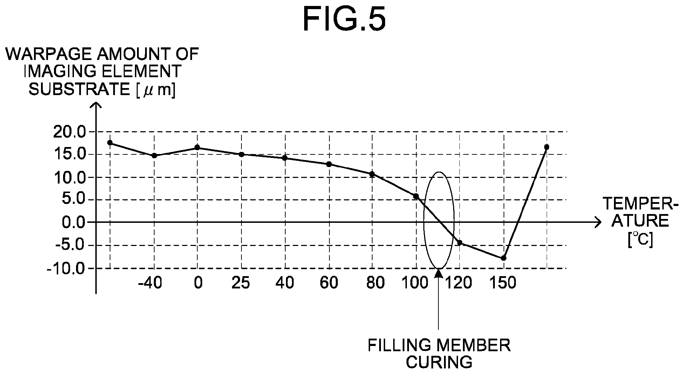

Note that the imaging element substrate 5 may be slightly warped even if the light-transmissive substrate 7 is stacked. Thus, in the present disclosure, slight warpage of the imaging element substrate 5 is corrected by devising the timing of curing the filling member 8. The timing of curing the filling member 8 will be described later with reference to FIG. 5.

Then, as illustrated in FIG. 4C, the structure in FIG. 4B is taken out from the heat treatment device 103, and the support substrate 100 is peeled off from the circuit board 2, whereby the high-quality imaging element package 1 in which the warpage of the imaging element substrate 5 is inhibited is completed.

### [3. Curing Timing of Filling Member]

Next, the timing of curing the filling member 8 will be described with reference to FIG. 5. FIG. 5 is an explanatory view of the timing of curing the filling member according to the present disclosure.

As illustrated in FIG. 5, the imaging element substrate 5 is warped by 10 [µm] or more in a temperature environment of -40 to 80[°C], but the amount of the warpage decreases when the temperature exceeds 80[°C]. Then, at a temperature from 100 to 120[°C], the amount of warpage decreases within ±5 [µm].

Therefore, in the present disclosure, the space between the imaging element substrate 5 and the light-transmissive substrate 7 and the frame body 6 is filled with the filling member 8 and the filling member 8 is cured in a state where heating is performed to a temperature from 100 to 120[°C].

As a result, the flatness of the imaging element substrate 5 can be maintained by holding the shape of the imaging element substrate 5 whose warpage amount is inhibited within ±5 [µm] with the cured filling member having a high elastic modulus of 8 to 10 [GPa].

### [4. Configuration Examples of Light-Transmissive Substrate]

Next, specific configuration examples of the light-transmissive substrate 7 according to the present disclosure will be described with reference to FIGS. 6A to 8. FIGS. 6A to 8 are cross-sectional explanatory views illustrating a configuration example of the light-transmissive substrate according to the present disclosure. Note that FIGS. 6A to 8 selectively illustrate portions of the imaging element substrate 5 and a light-transmissive substrate 7a among the components of the imaging element package 1, and illustration of other components is omitted.

As illustrated in FIG. 6A, a light-transmissive substrate 7a of a first configuration example is stacked on the imaging element substrate 5 in which a pixel array 52 is provided on a silicon substrate 51. The light-transmissive substrate 7a includes a glass substrate 71 and an infrared cut filter substrate 72. The glass substrate 71 is stacked on the imaging element substrate 5 via a transparent resin layer 81. The infrared cut filter substrate 72 is stacked on the glass substrate 71 via a transparent resin layer 82.

When the imaging element substrate 5 has a thickness of 120 to 130 [µm], the transparent resin layer 81 and the transparent resin layer 82 are formed to be thinner than the imaging element substrate 5, for example, to have a thickness of approximately 50 to 100 [µm]. Furthermore, similarly, a glass substrate having a thickness of, for example, approximately 50 to 100 [µm] is used as the glass substrate 71. As a result, a decrease in optical characteristics of the imaging element package 1 can be inhibited.

Furthermore, the infrared cut filter substrate 72 is formed of, for example, blue glass. Note that the light-transmissive substrate 7a may include a transparent substrate formed of borosilicate glass, a transparent/rigid resin cured product, quartz, and the like, instead of the infrared cut filter substrate 72. Furthermore, a transparent resin thin film may be formed on the surfaces of the infrared cut filter substrate 72 and the transparent substrate.

When the imaging element substrate 5 has a thickness of 120 to 130 [µm], a substrate having a thickness similar to or larger than that of the imaging element substrate 5, for example, a thickness of approximately 200 to 300 [µm] is used as the infrared cut filter substrate 72 and the transparent substrate.

Furthermore, a substrate having higher heat resistance than the imaging element substrate 5 and, when the imaging element substrate 5 has a CTE of approximately 4 [ppm/°C], having a CTE of 3 to 5 [ppm/°C] is used as the infrared cut filter substrate 72 and the transparent substrate. As a result, the light-transmissive substrate 7a can inhibit the warpage of the imaging element substrate 5 due to heat treatment with the infrared cut filter substrate 72 and the transparent substrate.

Furthermore, as illustrated in FIG. 6B, a light-transmissive substrate 7b of a second configuration example includes the glass substrate 71 and the infrared cut filter substrate 72. The glass substrate 71 is superimposed and fixed on the imaging element substrate 5 via a void by an adhesive member 91 provided on a peripheral edge of the light receiving surface of the imaging element substrate 5. The infrared cut filter substrate 72 is stacked on the glass substrate 71 via the transparent resin layer 82.

The glass substrate 71 is the same as the glass substrate 71 in FIG. 6A. The infrared cut filter substrate 72 is the same as the infrared cut filter substrate 72 in FIG. 6A. Note that the infrared cut filter substrate 72 may be the above-described transparent substrate. The light-transmissive substrate 7b can inhibit the warpage of the imaging element substrate 5 due to heat treatment with the infrared cut filter substrate 72 and the transparent substrate.

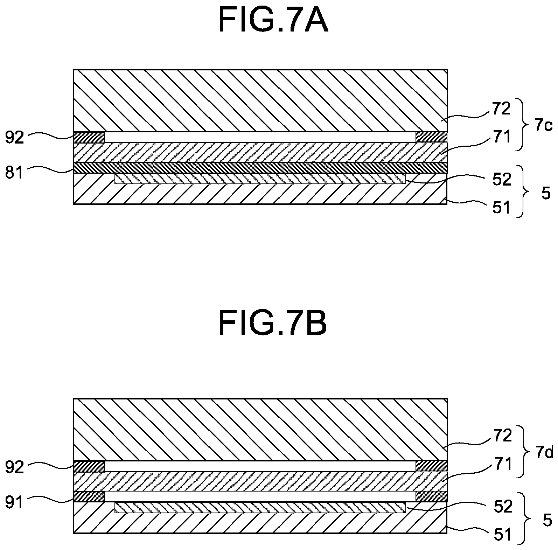

As illustrated in FIG. 7A, a light-transmissive substrate 7c of a third configuration example includes the glass substrate 71 and the infrared cut filter substrate 72. The glass substrate 71 is stacked on the imaging element substrate 5 via the transparent resin layer 81. The infrared cut filter substrate 72 is superimposed and fixed on the glass substrate 71 via a void by an adhesive member 92 provided on a peripheral edge of the light receiving surface of the glass substrate 71.

The glass substrate 71 is the same as the glass substrate 71 in FIG. 6A. The infrared cut filter substrate 72 is the same as the infrared cut filter substrate 72 in FIG. 6A. Note that the infrared cut filter substrate 72 may be the above-described transparent substrate. The light-transmissive substrate 7c can inhibit the warpage of the imaging element substrate 5 due to heat treatment with the infrared cut filter substrate 72 and the transparent substrate.

As illustrated in FIG. 7B, a light-transmissive substrate 7d of a fourth configuration example includes the glass substrate 71 and the infrared cut filter substrate 72. The glass substrate 71 is superimposed and fixed on the imaging element substrate 5 via a void by an adhesive member 91 provided on a peripheral edge of the light receiving surface of the imaging element substrate 5. The infrared cut filter substrate 72 is superimposed and fixed on the glass substrate 71 via a void by an adhesive member 92 provided on a peripheral edge of the light receiving surface of the glass substrate 71.

The glass substrate 71 is the same as the glass substrate 71 in FIG. 6A. The infrared cut filter substrate 72 is the same as the infrared cut filter substrate 72 in FIG. 6A. Note that the infrared cut filter substrate 72 may be the above-described transparent substrate. The light-transmissive substrate 7d can inhibit the warpage of the imaging element substrate 5 due to heat treatment with the infrared cut filter substrate 72 and the transparent substrate.

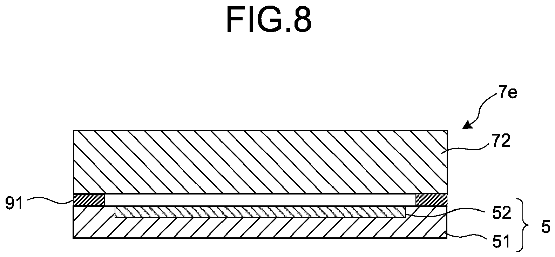

As illustrated in FIG. 8, a light-transmissive substrate 7e of a fifth configuration example includes the infrared cut filter substrate 72. The infrared cut filter substrate 72 is superimposed and fixed on the imaging element substrate 5 via a void by an adhesive member 91 provided on a peripheral edge of the light receiving surface of the imaging element substrate 5.

The infrared cut filter substrate 72 is the same as the infrared cut filter substrate 72 in FIG. 6A. Note that the infrared cut filter substrate 72 may be the above-described transparent substrate. The light-transmissive substrate 7d can inhibit the warpage of the imaging element substrate 5 due to heat treatment with the infrared cut filter substrate 72 and the transparent substrate.

### [5. Effects]

The imaging element package 1 includes the circuit board 2, the imaging element substrate 5, and the light-transmissive substrate 7. The imaging element substrate 5 is stacked on the circuit board 2. The light-transmissive substrate 7 is stacked on the imaging element substrate 5, and has higher heat resistance than the imaging element substrate 5. As a result, in the imaging element package 1, the light-transmissive substrate 7 serves as a reinforcing substrate for the imaging element substrate 5, so that the warpage of the imaging element substrate 5 due to heat treatment included in a manufacturing process can be inhibited.

The light-transmissive substrate 7e includes the infrared cut filter substrate 72. As a result, in the imaging element package 1, the warpage of the imaging element substrate 5 due to heat treatment can be inhibited without increasing manufacturing costs by using the existing infrared cut filter substrate 72 as a reinforcing substrate for the imaging element substrate 5.

The light-transmissive substrate 7a includes the glass substrate 71 and the infrared cut filter substrate 72. The glass substrate 71 is stacked on the imaging element substrate 5 via the transparent resin layer 81. The infrared cut filter substrate 72 is stacked on the glass substrate 71 via the transparent resin layer 82. As a result, in the imaging element package 1, the infrared cut filter substrate 72 serves as a reinforcing substrate for the imaging element substrate 5, so that the warpage of the imaging element substrate 5 due to heat treatment included in a manufacturing process can be inhibited.

The light-transmissive substrate 7b includes the glass substrate 71 and the infrared cut filter substrate 72. The glass substrate 71 is superimposed and fixed on the imaging element substrate 5 via a void by an adhesive member 91 provided on a peripheral edge of the light receiving surface of the imaging element substrate 5. The infrared cut filter substrate 72 is stacked on the glass substrate 71 via the transparent resin layer 82. As a result, in the imaging element package 1, the infrared cut filter substrate 72 serves as a reinforcing substrate for the imaging element substrate 5, so that the warpage of the imaging element substrate 5 due to heat treatment included in a manufacturing process can be inhibited.

The light-transmissive substrate 7c includes the glass substrate 71 and the infrared cut filter substrate 72. The glass substrate 71 is stacked on the imaging element substrate 5 via the transparent resin layer 81. The infrared cut filter substrate 72 is superimposed and fixed on the glass substrate 71 via a void by an adhesive member 92 provided on a peripheral edge of the light receiving surface of the glass substrate 71. As a result, in the imaging element package 1, the infrared cut filter substrate 72 serves as a reinforcing substrate for the imaging element substrate 5, so that the warpage of the imaging element substrate 5 due to heat treatment included in a manufacturing process can be inhibited.

The light-transmissive substrate 7d includes the glass substrate 71 and the infrared cut filter substrate 72. The glass substrate 71 is superimposed and fixed on the imaging element substrate 5 via a void by an adhesive member 91 provided on a peripheral edge of the light receiving surface of the imaging element substrate 5. The infrared cut filter substrate 72 is superimposed and fixed on the glass substrate 71 via a void by an adhesive member 92 provided on a peripheral edge of the light receiving surface of the glass substrate 71. As a result, in the imaging element package 1, the infrared cut filter substrate 72 serves as a reinforcing substrate for the imaging element substrate 5, so that the warpage of the imaging element substrate 5 due to heat treatment included in a manufacturing process can be inhibited.

The light-transmissive substrate 7e includes the infrared cut filter substrate 72. The infrared cut filter substrate 72 is superimposed and fixed on the imaging element substrate 5 via a void by an adhesive member 91 provided on a peripheral edge of the light receiving surface of the imaging element substrate 5. As a result, in the imaging element package 1, the infrared cut filter substrate 72 serves as a reinforcing substrate for the imaging element substrate 5, so that the warpage of the imaging element substrate 5 due to heat treatment included in a manufacturing process can be inhibited.

The imaging element package 1 further includes a frame-shaped frame body 6 stacked on the circuit board 2. The imaging element substrate 5 and the light-transmissive substrate 7 are housed in a region surrounded by the frame body 6. As a result, in the imaging element package 1, the light-transmissive substrate 7 is housed inside the frame body 6, so that the height can be more reduced than that of a package in which the light-transmissive substrate 7 is stacked on the frame body 6.

The imaging element package 1 includes the filling member 8. The space between the imaging element substrate 5 and the light-transmissive substrate 7 and the frame body 6 is filled with the filling member 8. The filling member 8 has a higher elastic modulus than the imaging element substrate 5. As a result, in the imaging element package 1, the elastic modulus corrects the warpage of the imaging element substrate 5 with the imaging element substrate 5, so that the warpage of the imaging element substrate 5 due to heat treatment can be inhibited.

The light-transmissive substrate 7 has a coefficient of thermal expansion having a difference within several ppm/°C from the coefficient of thermal expansion of the imaging element substrate 5. As a result, in the imaging element package 1, the warpage of the imaging element substrate 5 due to the difference between the coefficient of thermal expansion of the imaging element substrate 5 and the coefficient of thermal expansion of the light-transmissive substrate 7 can be inhibited.

The light-transmissive substrate 7 has a thickness equivalent to or larger than the thickness of the imaging element substrate 5. As a result, in the imaging element package 1, the heat resistance of the light-transmissive substrate 7 is increased, so that the warpage of the imaging element substrate 5 due to heat treatment can be further inhibited.

A method of manufacturing the imaging element package 1 includes: bonding the circuit board 2 to the support substrate 100 having a coefficient of thermal expansion with a difference within several tens ppm/°C from a coefficient of thermal expansion of the circuit board 2; stacking and reflowing the frame body 6 having a frame shape and the imaging element substrate 5 housed in a region surrounded by the frame body 6 on the circuit board 2 via the bump 3; and stacking the light-transmissive substrate 7 having higher heat resistance than the imaging element substrate 5 on the imaging element substrate 5. As a result, in the imaging element package 1, the warpage of the imaging element substrate 5 due to the difference between the coefficient of thermal expansion of the circuit board 2 and the coefficient of thermal expansion of the support substrate 100 can be inhibited.

The method of manufacturing the imaging element package 1 includes causing the space between the imaging element substrate 5 and the light-transmissive substrate 7 and the frame body 6 to be filled with the filling member 8; and thermally curing the filling member 8 in a state where heating is performed to a temperature at which the warpage of the imaging element substrate 5 is minimized. The flatness of the imaging element substrate 5 can be maintained by holding the shape of the imaging element substrate 5 whose warpage is minimized with the filling member 8.

Note that the effects set forth in the specification are merely examples and not limitations. Other effects may be exhibited.

Note that the present technology can also have the configurations as follows.
(1) An imaging element package including:
   a circuit board;
   an imaging element substrate stacked on the circuit board; and
   a light-transmissive substrate that is stacked on the imaging element substrate via a void by an adhesive member provided on a peripheral edge of a light receiving surface of the imaging element substrate and that has higher heat resistance than the imaging element substrate.
(2) The imaging element package according to (1), wherein the light-transmissive substrate includes an infrared cut filter substrate.
(3) The imaging element package according to (2),
   wherein the light-transmissive substrate includes:
   a glass substrate superimposed and fixed on the imaging element substrate via a void by an adhesive member provided on a peripheral edge of a light receiving surface of the imaging element substrate; and
   the infrared cut filter substrate stacked on the glass substrate via a transparent resin layer.
(4) The imaging element package according to (2),
   wherein the light-transmissive substrate includes:
   a glass substrate superimposed and fixed on the imaging element substrate via a void by an adhesive member provided on a peripheral edge of a light receiving surface of the imaging element substrate; and
   the infrared cut filter substrate superimposed and fixed on the glass substrate via a void by an adhesive member provided on a peripheral edge of a light receiving surface of the glass substrate.
(5) The imaging element package according to (2),
   wherein the light-transmissive substrate includes the infrared cut filter substrate superimposed and fixed on the imaging element substrate via a void by an adhesive member provided on a peripheral edge of a light receiving surface of the imaging element substrate.
(6) The imaging element package according to any one of (1) to (5), further including
   a frame body having a frame shape stacked on the circuit board,
   wherein the imaging element substrate and the light-transmissive substrate are housed in a region surrounded by the frame body.
(7) The imaging element package according to (6), further including
   a filling member having a higher elastic modulus than the imaging element substrate, space between the imaging element substrate and the light-transmissive substrate and the frame body being filled with the filling member.
(8) The imaging element package according to any one of (1) to (7),
   wherein the light-transmissive substrate has a coefficient of thermal expansion having a difference within several ppm/°C from a coefficient of thermal expansion of the imaging element substrate.
(9) The imaging element package according to any one of (1) to (8),
   wherein the light-transmissive substrate has a thickness equivalent to or larger than a thickness of the imaging element substrate.
(10) A method of manufacturing an imaging element package, including:
   bonding a circuit board to a support substrate having a coefficient of thermal expansion with a difference within several tens ppm/°C from a coefficient of thermal expansion of the circuit board;
   stacking and reflowing a frame body having a frame shape and an imaging element substrate housed in a region surrounded by the frame body on the circuit board via a bump; and
   stacking a light-transmissive substrate having higher heat resistance than the imaging element substrate on the imaging element substrate.
(11) The method of manufacturing an imaging element package according to (10), including:
   causing space between the imaging element substrate and the light-transmissive substrate and the frame body to be filled with a filling member; and
   thermally curing the filling member in a state where heating is performed to a temperature at which warpage of the imaging element substrate is minimized.

### Reference Signs List

- 1: IMAGING ELEMENT PACKAGE

- 2: CIRCUIT BOARD
- 3: BUMP
- 4: DAM MATERIAL
- 5: IMAGING ELEMENT SUBSTRATE
- 51: SILICON SUBSTRATE
- 52: PIXEL ARRAY
- 6: FRAME BODY
- 7, 7a, 7b, 7c, 7e: LIGHT-TRANSMISSIVE SUBSTRATE
- 71: GLASS SUBSTRATE
- 72: INFRARED CUT FILTER SUBSTRATE
- 8: FILLING MEMBER
- 81, 82: TRANSPARENT RESIN LAYER
- 91, 92: ADHESIVE MEMBER

## Claims

1. An imaging element package comprising:
a circuit board;
an imaging element substrate stacked on the circuit board; and
a light-transmissive substrate that is stacked on the imaging element substrate via a void by an adhesive member provided on a peripheral edge of a light receiving surface of the imaging element substrate and that has higher heat resistance than the imaging element substrate.

2. The imaging element package according to claim 1,
wherein the light-transmissive substrate includes an infrared cut filter substrate.

3. The imaging element package according to claim 2,
wherein the light-transmissive substrate includes:
a glass substrate superimposed and fixed on the imaging element substrate via a void by an adhesive member provided on a peripheral edge of a light receiving surface of the imaging element substrate; and
the infrared cut filter substrate stacked on the glass substrate via a transparent resin layer.

4. The imaging element package according to claim 2,
wherein the light-transmissive substrate includes:
a glass substrate superimposed and fixed on the imaging element substrate via a void by an adhesive member provided on a peripheral edge of a light receiving surface of the imaging element substrate; and
the infrared cut filter substrate superimposed and fixed on the glass substrate via a void by an adhesive member provided on a peripheral edge of a light receiving surface of the glass substrate.

5. The imaging element package according to claim 2,
wherein the light-transmissive substrate includes the infrared cut filter substrate superimposed and fixed on the imaging element substrate via a void by an adhesive member provided on a peripheral edge of a light receiving surface of the imaging element substrate.

6. The imaging element package according to claim 1, further comprising
a frame body having a frame shape stacked on the circuit board,
wherein the imaging element substrate and the light-transmissive substrate are housed in a region surrounded by the frame body.

7. The imaging element package according to claim 6, further comprising
a filling member having a higher elastic modulus than the imaging element substrate, space between the imaging element substrate and the light-transmissive substrate and the frame body being filled with the filling member.

8. The imaging element package according to claim 1,
wherein the light-transmissive substrate has a coefficient of thermal expansion having a difference within several ppm/°C from a coefficient of thermal expansion of the imaging element substrate.

9. The imaging element package according to claim 1,
wherein the light-transmissive substrate has a thickness equivalent to or larger than a thickness of the imaging element substrate.

10. A method of manufacturing an imaging element package, comprising:
bonding a circuit board to a support substrate having a coefficient of thermal expansion with a difference within several tens ppm/°C from a coefficient of thermal expansion of the circuit board;
stacking and reflowing a frame body having a frame shape and an imaging element substrate housed in a region surrounded by the frame body on the circuit board via a bump; and
stacking a light-transmissive substrate having higher heat resistance than the imaging element substrate on the imaging element substrate.

11. The method of manufacturing an imaging element package according to claim 10, comprising:
causing space between the imaging element substrate and the light-transmissive substrate and the frame body to be filled with a filling member; and
thermally curing the filling member in a state where heating is performed to a temperature at which warpage of the imaging element substrate is minimized.
